# NEUE EUROPÄISCHE PATENTSCHRIFT

(11) **EP 2 625 731 B2**
(45) Veröffentlichungstag und Bekanntmachung des Hinweises auf die Entscheidung über den Einspruch: **16.03.2022**
(45) Hinweis auf die Patenterteilung: 16.07.2014
(21) Anmeldenummer: 11764774.3
(22) Anmeldetag: 07.10.2011
(51) Int. Cl.: H01L 51/52, H01L 27/32

(54) **LEUCHTELEMENT MIT OLED-MODULEN**
LIGHTING ELEMENT HAVING OLED MODULES
ÉLÉMENT D'ÉCLAIRAGE COMPRENANT DES MODULES DELO

(30) Priorität: 07.10.2010 DE 102010042132
(43) Veröffentlichungstag der Anmeldung: 14.08.2013
(73) Patentinhaber: Tridonic GmbH & Co. KG, 6851 Dornbirn (AT)
(72) Erfinder: KIRCHHOF, Christian, 01099 Dresden (DE); ERITT, Michael, 01129 Dresden (DE); AMELUNG, Jörg, Dresden 01099 (DE)
(74) Vertreter: Thun, Clemens
(86) Internationale Anmeldenummer: PCT/EP2011/067543
(87) Internationale Veröffentlichungsnummer: WO 2012/045857

(56) Entgegenhaltungen:
- WO-A1-2006/030719
- WO-A1-2007/115651
- WO-A1-2008/090493
- WO-A1-2010/033299
- US-A1- 2005 248 935
- US-A1- 2007 120 167
- US-A1- 2008 264 759
- US-A1- 2009 114 928

## Beschreibung

Die Erfindung betrifft ein Leuchtelement mit einem ersten OLED-Modul (OLED: organische lichtemittierenden Diode) und einem zweiten OLED-Modul, die auf einem Trägerelement angeordnet sind, sowie mit elektrischen Leitern zur elektrischen Stromversorgung der beiden OLED-Module. Außerdem betrifft die Erfindung eine Leuchte mit einem derartigen Leuchtelement.

Durch eine OLED kann ein Lichtabgabeelement mit einem flächig ausgebildeten Lichtabgabebereich zur diffusen Lichtabgabe gebildet werden.

Aus dem Stand der Technik ist eine OLED bekannt, die eine Anode als erste Elektrode in Form einer transparenten ITO-Schicht (ITO: Indium-Zinn-Oxid) aufweist, eine Kathode als zweite Elektrode in Form einer metallischen Schicht sowie eine zwischen der Anode und der Kathode angeordnete organische Schicht, die zur Lichterzeugung dient. Das von der organischen Schicht erzeugte Licht wird durch die transparente ITO-Schicht hindurch nach außen abgegeben.

Die Anode weist eine Schichtstärke bzw. -dicke von ca. 100 nm auf, die Kathode eine Schichtstärke von etwa 100 bis 500 nm und die organische Schicht eine Schichtstärke von etwa 100 bis 200 nm. Die organische Schicht kann mehrere, beispielsweise sieben, Sublagen aufweisen.

Eine OLED ist ein stromgetriebenes Bauelement, bei dem in der Regel eine möglichst homogene Stromdichteverteilung und damit verbunden eine möglichst homogen erscheinende Lichtabgabe erwünscht ist. Die ITO-Schicht weist einen vergleichsweise hochohmigen Flächenwiderstand auf; dieser kann im Bereich von 10 bis 20 Ohm/Fläche liegen. Ein Kontaktbereich zur elektrischen Kontaktierung der ITO-Schicht ist dabei lediglich am Rand der OLED möglich. Daher kommt es im Fall eines vergleichsweise großflächigen Lichtabgabebereichs zu einer Inhomogenität der Stromeinspeisung, die zu einer sichtbaren Inhomogenität der Lichtabgabe führt. Somit ist für eine entsprechende OLED mit einer Lichtabgabe, die über den gesamten Lichtabgabebereich gleichmäßig erscheint, die Flächengröße des Lichtabgabebereichs auf maximal etwa 50 mm mal 50 mm limitiert.

Um größere abstrahlende Flächen zu realisieren, ist weiterhin bekannt, Metallverstärkungen in Form von Netzen, so genannte "Metallgrids" oder "Busbars", in die ITO-Schicht einzubringen. Hierdurch lässt sich der effektive Schichtwiderstand entsprechend der Beleuchtungsdichte erniedrigen, so dass größere gleichmäßig leuchtende Lichtabgabebereiche gebildet werden können. Allerdings bestehen diese Metallverstärkungen aus nicht lichtdurchlässigem Material, so dass die Lichtabgabe insgesamt reduziert ist. Metallgrids sind daher nur sinnvoll, wenn sie maximal ca. 25% der ITO-Fläche einnehmen. Eine mögliche Verbesserung wäre eine Erniedrigung des Widerstands durch Erhöhung der Dicke bzw. Stärke der Metallgrids; allerdings ist dies aufgrund von Strukturierungsmöglichkeiten und aufgrund der Schichtdicken der organischen Schichten nicht sinnvoll. Außerdem wird eine metallverstärkte ITO-Schicht lediglich an ihren Außenkanten elektrisch kontaktiert, so dass trotz eines verringerten Widerstands auch mit einem Metallgrid die maximale Flächengröße des Lichtabgabebereichs zur Erzielung einer homogenen Lichtabgabe limitiert ist.

Somit ist es erforderlich, zur Realisierung eines entsprechenden Leuchtelements mit einer, in diesem Sinne größeren Lichtabgabefläche mehrere OLEDs zu verwenden, die entsprechend zu einer größeren Fläche zusammengesetzt sind. Mit "OLED-Modul" wird vorliegend eine derartige Baueinheit bezeichnet.

Beispielsweise kann ein OLED-Modul einen rechteckigen bzw. quadratischen Lichtabgebebereich aufweisen, dessen Kantenlängen im Bereich von einigen Zentimetern liegen.

Aus der Schrift WO 2007/115651 A1 ist eine Anordnung von OLEDs mit homogener Lichtemission bekannt. Hierbei sind mehrere, in Reihe geschaltete OLEDs zu einer Matrix verschaltet. Eine weitere Matrix-Anordnung von Lichtabgabeelementen ist aus der Schrift WO 2006/030719 A1 bekannt.

Der Erfindung liegt die Aufgabe zugrunde, ein entsprechendes Leuchtelement anzugeben, das bei guten Leuchteigenschaften einfach hergestellt werden kann. Außerdem soll eine Leuchte mit einem solchen Leuchtelement angegeben werden.

Diese Aufgabe wird gemäß der Erfindung mit den in den unabhängigen Ansprüchen genannten Gegenständen gelöst. Besondere Ausführungsarten der Erfindung sind in den abhängigen Ansprüchen angegeben.

Gemäß der Erfindung ist ein Leuchtelement vorgesehen, das ein erstes OLED-Modul und ein zweites OLED-Modul aufweist, sowie ein Trägerelement, auf dem das erste OLED-Modul und das zweite OLED-Modul angeordnet sind. Weiterhin weist das Leuchtelement elektrische Leiter zur elektrischen Stromversorgung des ersten OLED-Moduls und des zweiten OLED-Moduls auf. Dabei weist das erste OLED-Modul wenigstens drei elektrische Kontaktbereiche zur Versorgung mit elektrischem Strom auf und das zweite OLED-Modul weist wenigstens drei weitere elektrische Kontaktbereiche zur Versorgung mit elektrischem Strom auf. Jeder der Kontaktbereiche ist jeweils mit einem der Leiter elektrisch leitend verbunden. Die elektrischen Leiter sind zumindest teilweise auf dem Trägerelement angeordnet; dabei sind die Leiter derart auf dem Trägerelement angeordnet, dass sie sich nicht überkreuzen.

Durch die wenigstens drei Kontaktbereiche des ersten OLED-Moduls und die wenigstens drei weiteren Kontaktbereiche des zweiten OLED-Moduls lässt sich eine besonders homogene Stromeinspeisung in die beiden OLED-Module und somit eine besonders gleichmäßige Lichtabgabe des Leuchtmoduls erzielen; durch die besondere, kreuzungsfreie Anordnung der elektrischen Leiter auf dem Trägerelement ist dabei eine besonders einfache Herstellung des Leuchtelements ermöglicht. Außerdem lässt sich ein besonders gleichförmiges optisches Erscheinungsbild des Leuchtelements erzielen, wenn sich die Leiter auf dem Trägerelement nicht überkreuzen.

Eine besonders gleichförmige Stromeinspeisung in das erste OLED-Modul lässt sich erzielen, wenn das erste OLED-Modul derart geformt ist, dass es einen ersten Randbereich aufweist und einen zweiten Randbereich, der dem ersten Randbereich gegenüberliegt, wobei ein erster Kontaktbereich der drei Kontaktbereiche mit einer ersten Elektrode des ersten OLED-Moduls elektrisch verbunden ist, ein zweiter Kontaktbereich der drei Kontaktbereiche ebenfalls mit der ersten Elektrode des ersten OLED-Moduls elektrisch verbunden ist und der erste Kontaktbereich an dem ersten Randbereich angeordnet ist und der zweite Kontaktbereich an dem zweiten Randbereich. Hierdurch wird eine Stromeinspeisung (bzw. Stromableitung) von zwei gegenüberliegenden Seiten an dem ersten OLED-Modul erzielt, wodurch eine verbesserte Gleichförmigkeit der Stromdichte und somit der Lichtabgabe ermöglicht ist.

Vorzugsweise weist dabei das erste OLED-Modul eine rechteckige Form, insbesondere eine quadratische Form auf, wobei der erste Randbereich durch einen ersten Seitenbereich der vier, durch die Form festgelegten Seitenbereiche gegeben ist und der zweite Randbereich durch denjenigen weiteren Seitenbereich, der dem ersten Seitenbereich gegenüberliegt oder der erste Randbereich durch einen, durch die Form festgelegten, ersten Eckenbereich gegeben ist und der zweite Randbereich durch einen weiteren Eckenbereich, der dem ersten Eckenbereich gegenüberliegt.

Eine insgesamt besonders großflächig erscheinende Lichtabgabefläche des Leuchtelements lässt sich vorteilhaft erzielen, wenn - wie erfindungsgemäß vorgesehen - das Leuchtelement außerdem mehrere weitere OLED-Module aufweist, die ebenfalls auf dem Trägerelement angeordnet sind, wobei das erste OLED-Modul, das zweite OLED-Modul und die weiteren OLED-Module derart auf dem Trägerelement angeordnet sind, dass sie Reihen und Spalten bilden. Dabei ist auf dem Trägerelement in einem Grenzbereich zwischen zwei der Spalten ein Arm eines ersten elektrischen Leiters der elektrischen Leiter angeordnet.

Erfindungsgemäß sind dabei diejenigen der OLED-Module, die eine der zwei Spalten bilden, elektrisch parallel geschaltet und mit dem Arm des ersten elektrischen Leiters elektrisch verbunden. Vorzugsweise ist dabei außerdem ein Arm eines zweiten elektrischen Leiters der elektrischen Leiter derart auf dem Trägerelement angeordnet, dass er sich zwischen denjenigen OLED-Modulen, die die eine der zwei Spalten bilden, einerseits und dem Trägerelement andererseits erstreckt. Auf diese Weise ist eine besonders einfache, kreuzungsfreie Anordnung der Leiter auf dem Trägerelement, insbesondere für eine Parallelschaltung der OLED-Module der betreffenden Spalte, ermöglicht.

Eine besonders große Lichtabgabefläche des Leuchtelements lässt sich vorteilhaft erzielen, wenn das erste OLED-Modul, das zweite OLED-Modul und die weiteren OLED-Module jeweils eine Lichtabgabefläche aufweisen, die größer ist als 1 cm², vorzugsweise größer als 4 cm², besonders bevorzugt größer als 20 cm²

Vorteilhaft weist ein elektrischer Leiter der elektrischen Leiter einen zumindest teilweise lichtdurchlässigen Leiterbereich auf, der zwischen dem ersten OLED-Modul und dem Trägerelement angeordnet ist. Hierdurch ist eine im Wesentlichen ungehinderte Lichtabgabe des OLED-Moduls in zwei entgegengesetzte Richtungen ermöglicht. Insbesondere lässt sich durch diese Ausgestaltung erzielen, dass der Leiterbereich die Lichtabgabe des Leuchtelements nicht nennenswert beeinträchtigt, beispielsweise durch Streuung an Randbereichen bzw. Kanten des Leiters oder dergleichen. Besonders vorteilhaft lässt sich dies erzielen, wenn das Leuchtelement derart gestaltet ist, dass, in einem Querschnitt durch den ersten Kontaktbereich und den zweiten Kontaktbereich und das Trägerelement betrachtet, zwischen dem ersten OLED-Modul und dem Trägerelement ein länglicher Zwischenraum gebildet ist und der Leiterbereich mehr als die Hälfte, vorzugsweise mehr als 80%, besonders bevorzugt 100% der Längserstreckung des Zwischenraums einnimmt. Auf diese Weise lassen sich insbesondere Kanten des Leiters, die eine Lichtabgabe negativ beeinflussen könnten, zuverlässig verhindern.

Vorteilhaft ist das Trägerelement zumindest teilweise lichtdurchlässig und besteht dabei beispielsweise aus Glas, PMMA (Polymethylmethacrylat) oder aus einer Folie, beispielsweise aus PET (Polyethylenterephthalat) oder es ist nicht lichtdurchlässig und besteht dabei beispielsweise aus Metall oder Kunststoff.

Die drei elektrischen Kontaktbereiche sind vorzugsweise jeweils mit einem der Leiter über einen Leitkleber, eine Weichlötung, ein Flexkabel, einen Klemmkontakt oder einen mechanischen Federkontakt elektrisch leitend verbunden.

Die elektrischen Leiter sind vorteilhaft aus einem Metall, wie beispielsweise Aluminium, Silber, Chrom oder Kupfer oder aus einer Metalllegierung gebildet, das bzw. die auf dem Trägerelement aufgebracht ist. Die elektrischen Leiter können vorteilhaft auch aus einem transparenten Material gebildet sein, beispielsweise aus ITO oder FTO (Fluor dotiertes Zinnoxid) oder ZnO (Zink Oxid) oder PEDOT (Poly-3,4-ethylendioxythiophen), das auf dem Trägerelement aufgebracht ist.

Gemäß einem weiteren Aspekt der Erfindung ist eine Leuchte, insbesondere zur Raumbeleuchtung, vorgesehen, die ein erfindungsgemäßes Leuchtelement aufweist. Dabei kann das Leuchtelement vorteilhaft die einzige Lichtquelle der Leuchte darstellen.

Die Erfindung wird im Folgenden anhand von Ausführungsbeispielen und mit Bezug auf die Zeichnungen näher erläutert. Es zeigen:
- Fig. 1: eine Skizze zu einem ersten Ausführungsbeispiel eines erfindungsgemäßen Leuchtelements,
- Fig. 2: eine Skizze zu einer Variante des in Fig. 1 gezeigten Leuchtelements,
- Fig. 3: eine Querschnitt-Skizze zu der in Fig. 2 gezeigten Variante,
- Fig. 4: eine Skizze zu einem zweiten Ausführungsbeispiel,
- Fig. 4a: eine Querschnitt-Skizze zu dem in Fig. 4 gezeigten Ausführungsbeispiel und
- Fig. 5: eine Skizze zu einem Beispiel. (Es handelt sich dabei nicht um einen Teil der Erfindung.)

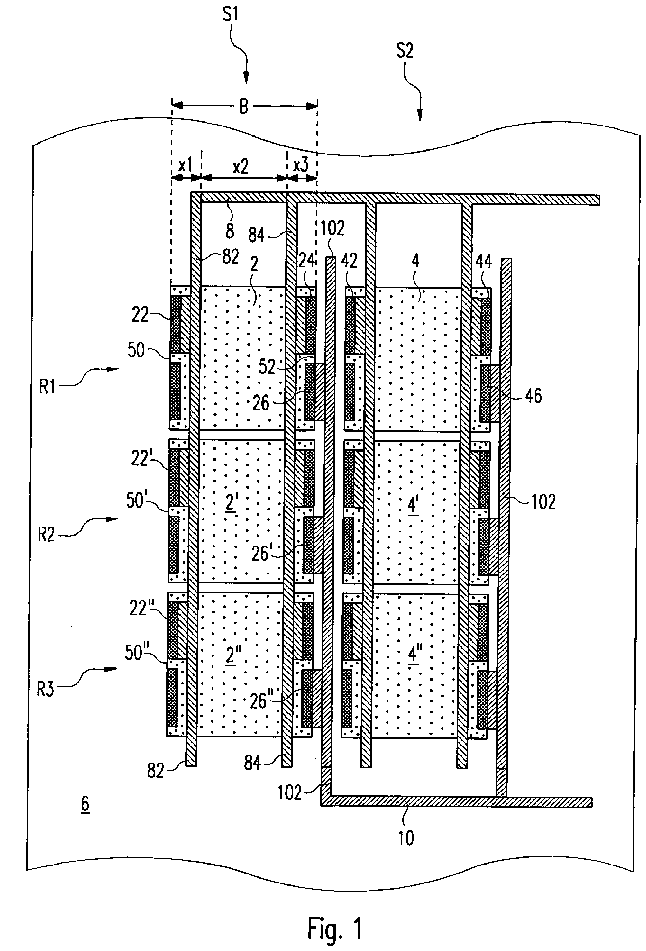

In Fig. 1 ist eine Aufsicht auf ein erstes Ausführungsbeispiel eines erfindungsgemäßen Leuchtelements skizziert. Das Leuchtelement weist ein erstes OLED-Modul 2 sowie ein zweites OLED-Modul 4 auf. Das erste OLED-Modul 2 weist insbesondere, wie eingangs bereits angedeutet, eine erste Elektrode als Anode auf, eine zweite Elektrode als Kathode, sowie eine zwischen den beiden Elektroden angeordnete organische Schicht zur Lichterzeugung. Insbesondere kann das erste OLED-Modul 2 derart gestaltet sein, dass es an Elektroden lediglich die beiden genannten Elektroden aufweist, also keine weitere Elektrode.

Insbesondere kann das erste OLED-Modul 2 weiterhin derart gestaltet sein, dass sich die genannten drei Schichten jeweils bis an seitliche Randbereiche des OLED-Moduls 2 erstrecken. Außerdem kann das erste OLED-Modul 2 biegsam bzw. flexibel sein. Das zweite OLED-Modul 4 kann in entsprechender Weise aufgebaut sein.

Weiterhin weist das Leuchtelement ein Trägerelement 6 auf, auf dem das erste OLED-Modul 2 und das zweite OLED-Modul 4 angeordnet sind. Bei dem Trägerelement 6 kann es sich um ein im Wesentlichen zweidimensionales Bauteil handeln, also beispielsweise um ein plattenförmiges Bauteil, so dass zwei gegenüberliegende, große Flachseiten gebildet sind, wobei die beiden OLED-Module 2, 4 vorzugsweise auf lediglich einer der beiden Flachseiten angeordnet sind. Das Trägerelement 6 kann dabei biegsam bzw. flexibel sein. Insbesondere können die beiden OLED-Module 2, 4 auf dem Trägerelement 6 jeweils mechanisch fixiert sein, vorzugsweise unmittelbar mechanisch fixiert sein, beispielsweise über eine Verschraubung und/oder eine Verklebung.

Außerdem weist das Leuchtelement elektrische Leiter 8, 10 auf, die einer elektrischen Stromversorgung der beiden OLED-Module 2, 4 dienen, und zwar umfassend einen ersten Leiter 10 und einen zweiten Leiter 8.

Das erste OLED-Modul 2 weist drei Kontaktbereiche 22, 24, 26 zur Versorgung mit elektrischem Strom auf, und zwar einen ersten Kontaktbereich 22, einen zweiten Kontaktbereich 24 und einen dritten Kontaktbereich 26. Die drei Kontaktbereiche 22, 24, 26 können - wie in Fig. 1 angedeutet - jeweils länglich gestaltet sein und sich dabei jeweils längs eines geradlinig verlaufenden Randbereichs des ersten OLED-Moduls 2 erstrecken. Jeder der drei Kontaktbereiche 22, 24, 26 kann entweder mit der Anode oder mit der Kathode des ersten OLED-Moduls 2 elektrisch leitend verbunden sein.

Das zweite OLED-Modul 4 weist drei weitere Kontaktbereiche 42, 44, 46 zur Versorgung mit elektrischem Strom auf, die vorzugsweise in analoger Weise zu den zuerst genannten drei Kontaktbereichen 22, 24, 26 ausgebildet sind.

Jeder der Kontaktbereiche 22, 24, 26, 42, 44, 46 ist mit einem der beiden elektrischen Leiter 8, 10 elektrisch leitend verbunden. Im gezeigten Beispiel ist der erste Kontaktbereich 22 mit dem zweiten Leiter 8 verbunden, der zweite Kontaktbereich 24 ebenfalls mit dem zweiten Leiter 8 und der dritte Kontaktbereich 26 mit dem ersten Leiter 10. Beispielsweise können in diesem Fall der erste Kontaktbereich 22 und der zweite Kontaktbereich 24 mit der Anode des ersten OLED-Moduls 2 elektrisch leitend verbunden sein und der dritte Kontaktbereich 26 mit der Kathode des ersten OLED-Moduls 2. Dies ist insbesondere vorteilhaft, wenn die Anode einen vergleichsweise hohen Widerstand aufweist, wie das beispielsweise der Fall ist, wenn die Anode aus einer ITO-Schicht gebildet ist.

In analoger Weise sind im gezeigten Beispiel die weiteren Kontaktbereiche 42 und 44 des zweiten OLED-Moduls 4 mit dem zweiten Leiter 8 verbunden und der weitere Kontaktbereich 46 mit dem ersten Leiter 10.

Es sei jedoch ausdrücklich erwähnt, dass auch zwei der drei Kontaktbereiche 22, 24, 26 des ersten OLED-Moduls 2 mit der Kathode des ersten OLED-Moduls 2 verbunden sein können und der entsprechend dritte Kontaktbereich mit der Anode. Entsprechendes gilt für das zweite OLED-Modul 4.

Die Verbindung zwischen dem ersten Kontaktbereich 22 und dem zweiten Leiter 8 kann beispielsweise über einen Leitkleber, eine Weichlötung, ein Flexkabel, einen Klemmkontakt oder einen mechanischen Federkontakt vorgesehen sein. Entsprechendes gilt auch für die jeweiligen Verbindungen zwischen dem zweiten Kontaktbereich 24, dem dritten Kontaktbereich 26 bzw. den weiteren drei Kontaktbereichen 42, 44, 46 und jeweils dem betreffenden der elektrischen Leiter 8, 10.

Die elektrischen Leiter 8, 10 sind zumindest teilweise auf dem Trägerelement 6 angeordnet bzw. aufgebracht. Dabei sind die Leiter 8, 10 derart auf dem Trägerelement 6 angeordnet, dass sie sich nicht überkreuzen. Hierdurch ist eine besonders einfache Herstellung des Leuchtelements ermöglicht. Außerdem ist hierdurch ermöglicht, dass das Erscheinungsbild des Leuchtelements keine Kreuzungspunkte von elektrischen Leitern aufweist und daher besonders ebenmäßig ist. Dies ist insbesondere von Vorteil, wenn das Leuchtelement als Lichtquelle einer Leuchte, beispielsweise zur Raumbeleuchtung verwendet wird.

Die elektrischen Leiter 8, 10 können aus einem Metall gebildet sein, wie beispielsweise Aluminium, Silber, Chrom oder Kupfer. Sie können auch aus einer Metalllegierung gebildet sein. Sie können auch aus einem transparenten Material gebildet sein, beispielsweise aus ITO oder FTO oder ZnO oder PEDOT. Dabei kann das betreffende Material auf dem Trägerelement 6 - vorzugsweise unmittelbar auf einer Oberfläche des Trägerelements 6 - aufgebracht sein. Insbesondere können die Leiter 8, 10 auf lediglich einer der beiden Flachseiten des Trägerelements 6 angeordnet sein, insbesondere auf derselben Flachseite wie die beiden OLED-Module 2, 4.

Die Anordnung der elektrischen Leiter 8, 10 unmittelbar auf dem Trägerelement 6 kann derart gestaltet sein, dass die Abstände zwischen den Kontaktbereichen 22, 24, 26 usw. einerseits und den Leitern 8, 10 bzw. Armen der Leiter 8, 10 unmittelbar auf dem Trägerelement 6 andererseits weniger als 5 mm, vorzugsweise weniger als 2 mm betragen.

Wie in Fig. 1 exemplarisch skizziert, kann das erste OLED-Modul 2 derart geformt sein, dass es einen ersten Randbereich 50 aufweist und einen zweiten Randbereich 52, der dem ersten Randbereich 50 gegenüberliegt. Dabei kann der erste Kontaktbereich 22 an dem ersten Randbereich 50 angeordnet sein und der zweite Kontaktbereich 52 an dem zweiten Randbereich 52, wobei sowohl der erste Kontaktbereich 22, als auch der zweite Kontaktbereich 24 mit ein und derselben Elektrode, insbesondere mit der Anode, des ersten OLED-Moduls 2 verbunden ist. Auf diese Weise lässt sich eine Stromeinspeisung von zwei gegenüberliegenden Seiten in das erste OLED-Modul 2 bewirken, wodurch eine besonders gleichförmige Stromdichtverteilung ermöglicht ist und in der Folge eine besonders homogene Lichtabgabe. Die Anode des ersten OLED-Moduls 2 kann dabei beispielsweise in Form einer ITO-Schicht gegeben sein.

Wenn, wie in Fig. 1 exemplarisch skizziert, das erste OLED-Modul 2 eine rechteckige Form aufweist, beispielsweise eine quadratische Form, lässt sich dabei eine vergleichsweise einfache und entsprechend wirkungsvolle Kontaktierung erzielen, wenn der erste Randbereich 50 durch einen ersten Seitenbereich der vier, durch die rechteckige Form festgelegten Seitenbereiche gegeben ist und der zweite Randbereich 52 durch denjenigen weiteren Seitenbereich, der dem ersten Seitenbereich gegenüberliegt. Alternativ kann (in den Figuren nicht gezeigt) beispielsweise der erste Randbereich durch einen, durch die rechteckige Form festgelegten, ersten Eckenbereich gegeben sein und der zweite Randbereich durch einen weiteren Eckenbereich, der dem ersten Eckenbereich diagonal gegenüberliegt.

Für die weiteren drei Kontaktbereiche 42, 44, 46 des zweiten OLED-Moduls 4 gilt Analoges.

Wie in Fig. 1 exemplarisch skizziert, kann das Leuchtelement außerdem mehrere weitere OLED-Module 2', 2", 4', 4" aufweisen, die ebenfalls auf dem Trägerelement 6 angeordnet sind und vorzugsweise analog oder baugleich zu dem ersten OLED-Modul 2 bzw. zu dem zweiten OLED-Modul 4 gestaltet und analog auf dem Trägerelement 6 angeordnet sind. Dabei sind vorteilhaft das erste OLED-Modul 2, das zweite OLED-Modul 4 und die weiteren OLED-Module 2', 2", 4', 4" derart auf dem Trägerelement 6 angeordnet, dass sie Reihen *R1*, *R2, R3* und Spalten *S1, S2* bilden. Auf diese Weise lässt sich eine insgesamt besonders groß erscheinende Lichtabgabefläche des Leuchtelements erzielen. Die OLED-Module 2, 2', 2", 4, 4', 4" können also sozusagen matrixförmig auf dem Trägerelement 6 angeordnet sein.

Lediglich beispielhaft ist in Fig. 1 der Fall skizziert, in dem das Leuchtelement insgesamt sechs OLED-Module 2, 2', 2", 4, 4', 4" aufweist, wobei das erste OLED-Modul 2 und das zweite OLED-Modul 4 die erste Reihe *R1* bilden, die mit 2' und 4' bezeichneten weiteren OLED-Module die zweite Reihe *R2* und die mit 2" und 4" bezeichneten weiteren OLED-Module die dritte Reihe *R3*. Die OLED-Module 2, 2', 2" bilden die erste Spalte *S1* und die OLED-Module 4, 4', 4" bilden die zweite Spalte *S2*. Offensichtlich lassen sich auf diese Weise durch eine entsprechend gewählte Anzahl und Anordnung von OLED-Modulen grundsätzlich beliebig viele Reihen bzw. Spalten bilden, so dass grundsätzlich das Leuchtelement mit einem beliebig großen Lichtabgabebereich gestaltet werden kann.

Beispielsweise kann jedes der OLED-Module 2, 2', 2", 4, 4', 4" einen Lichtabgabebereich mit einer Fläche aufweisen, die größer als 1 cm² ist, vorzugsweise größer als 4 cm², besonders bevorzugt größer als 20 cm². Es können OLED-Module verwendet werden, deren Lichtabgabebereiche jeweils eine Fläche von mehr als 25 cm² aufweisen. Insbesondere können sämtliche OLED-Module 2, 2', 2", 4, 4', 4" des Leuchtelements Lichtabgabebereiche mit ein und derselben Flächengröße aufweisen.

Die Abstände zwischen den OLED-Modulen 2, 2', 2", 4, 4', 4" können im Vergleich zu der Größe der Lichtabgabereiche verhältnismäßig klein sein, so dass alle OLED-Module 2, 2', 2", 4, 4', 4" zusammen insgesamt den Eindruck lediglich einer, entsprechend großen, zusammengehörigen Lichtabgabefläche des Leuchtelements erwecken. Beispielsweise kann vorgesehen sein, dass die Abstände zwischen den OLED-Modulen 2, 2', 2", 4, 4', 4" weniger als 1 cm, beispielsweise zwischen 1 mm und 1cm betragen. Es kann auch vorgesehen sein, dass die Abstände im Fall von rechteckigen OLED-Modulen weniger als 30%, vorzugsweise weniger als 15% oder weniger als 10% einer der Kanten- bzw. Seitenlängen eines der OLED-Module 2, 2', 2", 4, 4', 4" betragen.

Eine einfache kreuzungsfreie Anordnung der Leiter 8, 10 auf dem Trägerelement 6 ist in diesem Fall ermöglicht, wenn auf dem Trägerelement 6 in einem Grenzbereich zwischen zwei der Spalten *S1, S2* ein Arm 102 eines der elektrischen Leiter, im gezeigten Beispiel des ersten elektrischen Leiters 10, angeordnet ist.

Diese Anordnung ist besonders vorteilhaft, wenn diejenigen der OLED-Module 2, 2', 2", 4, 4', 4", die eine der zwei Spalten *S1, S2* bilden, elektrisch parallel geschaltet sind und mit dem Arm 102 verbunden sind. Hierzu kann der Arm 102 auf dem Trägerelement 6 insbesondere so angeordnet sein, dass er sich zur elektrischen Verbindung mit allen OLED-Modulen 2, 2', 2" der betreffenden Spalte *S1* eignet. In dem in Fig. 1 gezeigten Beispiel bilden die OLED-Module 2, 2'und 2" die erste Spalte *S1.* Jedes dieser OLED-Module 2, 2'und 2" ist mit dem Arm 102 verbunden, und zwar das OLED-Modul 2 über den dritten Kontaktbereich 26, das OLED-Modul 2' über einen weiteren Kontaktbereich 26' und das OLED-Modul 2" über einen weiteren Kontaktbereich 26".

Wie ebenfalls in Fig. 1 beispielhaft skizziert, kann zur vorteilhaften elektrischen Kontaktierung außerdem ein Arm 82 eines weiteren elektrischen Leiters 8 der elektrischen Leiter 8, 10 - hier des zweiten elektrischen Leiters 8 - derart auf dem Trägerelement 6 angeordnet sein, dass er sich zwischen denjenigen OLED-Modulen 2, 2', 2", die die eine der zwei Spalten *S1, S2* bilden, hier die erste Spalte *S1* bilden, einerseits und dem Trägerelement 6 andererseits erstreckt. Hierdurch ist insbesondere eine vergleichsweise einfache Parallelschaltung der OLED-Module 2, 2', 2" der betreffenden Spalte *S1* ermöglicht. Im gezeigten Beispiel ist der Arm 82 über den ersten Kontaktbereich 22 mit dem ersten OLED-Modul 2 verbunden, über einen weiteren Kontaktbereich 22'mit dem weiteren OLED-Modul 2' und über einen weiteren Kontaktbereich 22" mit dem weiteren OLED-Modul 2' .

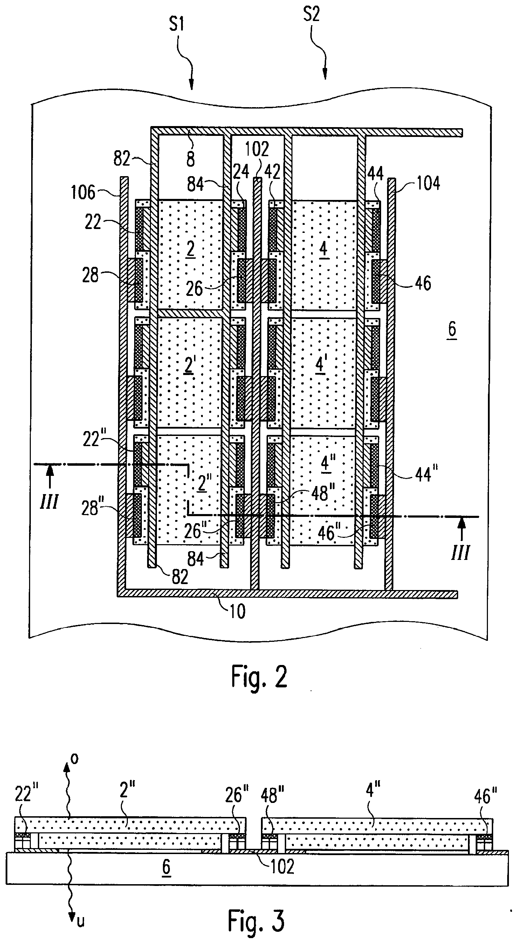

In Fig. 2 ist eine Variante des in Fig. 1 gezeigten Leuchtelements skizziert. Die Bezugszeichen sind dabei analog gebraucht. Hierbei ist vorgesehen, dass das erste OLED-Modul 2 vier Kontaktbereiche 22, 24, 26, 28 aufweist, wobei jeweils zwei gegenüberliegende Kontaktbereiche gebildet sind, die mit einer der beiden Elektroden verbunden sind. Dementsprechend sind im gezeigten Beispiel die zueinander gegenüberliegend angeordneten Kontaktbereiche 22 und 24 mit dem zweiten Leiter 8 elektrisch verbunden und die ebenfalls zueinander gegenüberliegend angeordneten Kontaktbereiche 26 und 28 mit dem ersten Leiter 10. Durch eine derartige Gestaltung lässt sich eine weitergehende Verbesserung der Homogenität der Lichtabgabe erzielen. Zur Kontaktierung ist entsprechend der gegenüberliegenden Anordnung vorteilhaft ein weiterer Arm 106 des einen elektrischen Leiters, hier also des ersten Leiters 10, vorgesehen bzw. auf dem Trägerelement 6 angeordnet, der mit Bezug auf die betroffene Spalte, hier also mit Bezug auf die Spalte *S1,* gegenüberliegend zu dem zuerst genannten Arm 102 des einen bzw. des ersten elektrischen Leiters 10, angeordnet ist.

Entsprechend kann auch ein weiterer Arm 84 des weiteren bzw. des zweiten Leiters 8 zur Realisierung der beschriebenen gegenüberliegenden Stromeinspeisung auf dem Trägerelement 6 vorgesehen sein, der insbesondere mit Bezug auf die betreffende Spalte *S1* gegenüberliegend von dem zuerst genannten Arm 82 des weiteren bzw. des zweiten Leiters 8 angeordnet ist.

Natürlich kann im Fall von mehreren Spalten die oben beschriebene Anordnung für jede der Spalten in analoger Weise vorgesehen sein.

In Fig. 3 ist ein Querschnitt längs der Markierung *III-III* in Fig. 2 skizziert. Dieser Querschnitt verläuft durch das weitere OLED-Modul 2", und zwar durch den dortigen Kontaktbereich 22" und den, in der skizzierten Aufsicht "höhenversetzt" zu diesem angeordneten, Kontaktbereich 26" und im Weiteren durch das weitere OLED-Modul 4" und die dortigen, zueinander gegenüberliegenden Kontaktbereiche 48" und 46". Man erkennt, dass der Arm 102, der in dem Grenzbereich zwischen den zwei Spalten *S1, S2* angeordnet ist, elektrisch einerseits mit dem weiteren Kontaktbereich 26" des OLED-Moduls 2" der einen der zwei Spalten *S1, S2* und andererseits mit dem weiteren Kontaktbereich 48" des OLED-Moduls 4" der anderen der zwei Spalten *S1,* S2 verbunden ist. Der Arm 102 kann also vorteilhaft zur Stromversorgung der genannten zwei Spalten *S1, S2* dienen.

Eine Lichtabgabe des Leuchtelements kann in eine erste Richtung *o* vorgesehen sein, mit Bezug auf Fig. 3 nach oben, die mit Bezug auf das erste OLED-Modul 2 von dem Trägerelement 6 weg weist. Eine Lichtabgabe kann aber auch in eine zweite Richtung *u* vorgesehen sein, mit Bezug auf Fig. 3 nach unten, die der ersten Richtung *o* entgegen gerichtet ist, also mit Bezug auf das erste OLED-Modul 2 zu dem Trägerelement 6 weist. Letzteres ist natürlich nur sinnvoll, wenn das Trägerelement 6 zumindest teilweise lichtdurchlässig ist. Beispielsweise kann das Trägerelement 6 in diesem Fall aus Glas oder PMMA gebildet sein oder aus einer Folie, beispielsweise aus PET, gebildet sein bzw. bestehen. Wenn jedoch nur eine Lichtabgabe in die erste Richtung *o* vorgesehen ist, kann das Trägerelement 6 auch lichtundurchlässig gestaltet sein und beispielsweise aus Metall oder Kunststoff bestehen.

Der Arm 82 des zweiten Leiters 8 kann so gestaltet sein, dass er sich lediglich entlang von Randbereichen 50, 50', 50" der betreffenden OLED-Module 2, 2', 2" erstreckt. Auf diese Weise lässt sich erzielen, dass eine Lichtabgabe der betreffenden OLED-Module 2, 2', 2" durch den Arm 82 besonders wenig beeinträchtigt ist. Beispielsweise kann vorgesehen sein, dass die betreffenden Randbereiche 50, 50', 50" lediglich eine Breite *x1* aufweisen, die kleiner ist als 25%, vorzugsweise kleiner als 20% oder kleiner als 10% einer Kantenlänge *B* der OLED-Module 2, 2', 2", beispielsweise der Breite der betreffenden Spalte *S1*. Entsprechendes gilt für den weiteren Arm 84 des zweiten Leiters 8; die den zuletzt genannten Arm 84 in diesem Sinne betreffenden Randbereiche können dementsprechend eine Breite *x2* aufweisen, die kleiner ist als 25%, vorzugsweise kleiner als 20% oder kleiner als 10% der Kantenlänge *B*. Auf diese Weise ist ermöglicht, dass die OLED-Module 2, 2', 2" der betreffenden Spalte *S1* über eine Breite *x2 = B - x1 - x2* in ihrer Lichtabgabe in die zweite Richtung *u* bzw. nach unten im Wesentlichen durch keinen elektrischen Leiter bzw. Arm eines elektrischen Leiters beeinträchtigt sind.

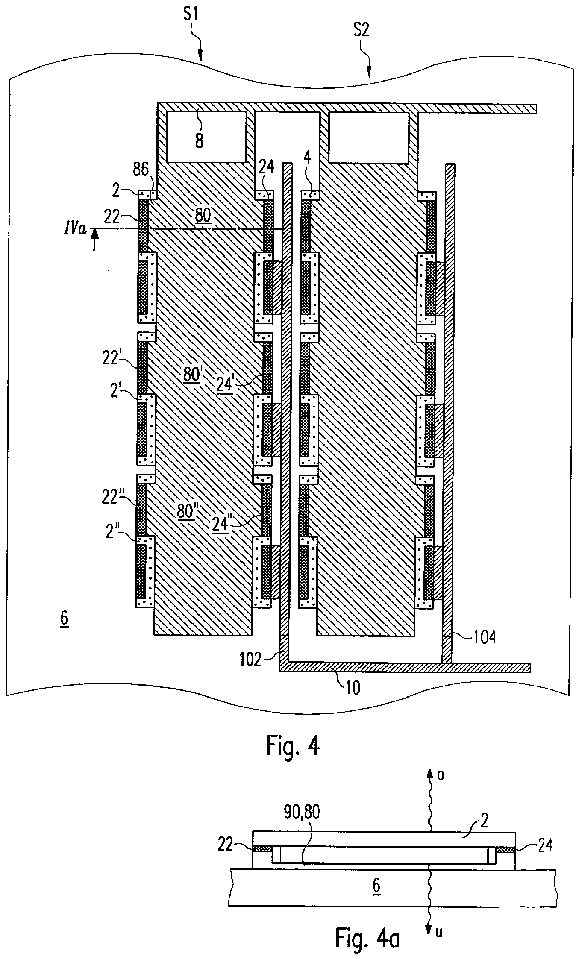

In Fig. 4 ist ein zweites Ausführungsbeispiel skizziert. Im Folgenden wird lediglich auf die Unterscheide zum ersten Ausführungsbeispiel eingegangen. Soweit nicht anders angegeben, gelten die obigen Ausführungen auch sinngemäß für dieses Ausführungsbeispiel. Die Bezugszeichen sind analog verwendet.

Im Unterschied zum ersten Ausführungsbeispiel weist einer der Leiter 8, 10, hier beispielhaft der zweite Leiter 8, einen Leiterbereich 80 auf, der zwischen dem ersten OLED-Modul 2 und dem Trägerelement 6 angeordnet ist und dabei zumindest teilweise lichtdurchlässig gestaltet ist. Hierzu kann der Leiterbereich 80 aus einem transparenten Material gebildet sein, beispielsweise aus ITO oder FTO oder ZnO oder PEDOT. Auch die weiteren Bereiche des zweiten Leiters 8 bzw. weitere Leiter 10 können entsprechend ausgebildet und angeordnet sein.

In Fig. 4a ist ein dazugehöriger Querschnitt längs der in Fig. 4 mit *IVa* bezeichneten Linie im Bereich des ersten OLED-Moduls 2 skizziert. Der skizzierte Querschnitt verläuft durch den ersten Kontaktbereich 22, den zweiten Kontaktbereich 24 und das Trägerelement 6. Die Ausgestaltung ist dabei derart, dass, in diesem Querschnitt betrachtet, zwischen dem ersten OLED-Modul 2 und dem Trägerelement 6 ein länglicher Zwischenraum 90 gebildet ist und der Leiterbereich 80 mehr als die Hälfte, vorzugsweise mehr als 80% der Längserstreckung des Zwischenraums 90 einnimmt. Besonders bevorzugt nimmt der Leiterbereich 80, wie in Fig. 4a der Fall, die gesamte Längserstreckung des Zwischenraums 90 ein.

Auf diese Weise kann der Leiterbereich 80 so großflächig ausgestaltet sein, dass er keine Ränder bzw. Kanten bildet, die die Lichtabgabe in die zweite Richtung *u* bzw. nach "unten" nennenswert stören könnten.

Wie wiederum aus Fig. 4 beispielhaft hervorgeht, erstreckt sich der Leiterbereich 80 normal zu einer Verbindungslinie zwischen dem ersten Kontaktbereich 22 und dem zweiten Kontaktbereich 24 - also beispielsweise längs der Haupterstreckung der ersten Spalte *S1* - ebenfalls vorteilhaft über einen größeren Bereich des ersten OLED-Moduls 2, beispielsweise wiederum zu mindestens 80%, besonders bevorzugt über die gesamte Erstreckung des ersten OLED-Moduls 2 in dieser Richtung.

Für die weiteren OLED-Module 2', 2" der betreffenden Spalte *S1* gilt entsprechendes, so dass weitere entsprechende Leiterbereiche 80', 80" gebildet sind. Ebenso gilt entsprechendes für die zweite Spalte *S2* bzw. gegebenenfalls für weitere Spalten.

In den anhand der Figuren 1 bis 4 dargestellten Ausführungsbeispielen ist die Anordnung der elektrischen Leiter 8, 10 derart, dass sich der erste Leiter 10 von einer ersten Seite her, in den Figuren von unten her, zu den OLED-Modulen 2, 2', 2", 4, 4', 4" hin erstreckt und der zweite Leiter 8 von einer zweiten Seite her, in den Figuren von oben her, die der ersten Seite mit Bezug auf die OLED-Module 2, 2', 2", 4, 4', 4" gegenüberliegt. Die genannte Arme 102, 104 und gegebenenfalls 106 des ersten Leiters 10 erstrecken sich von der ersten Seite her zumindest im Wesentlichen zwischen den Spalten *S1, S2* bzw. entlang der Ränder außerhalb der äußeren Spalten bis zur zweiten Seite. Die Arme 82, 84 des zweiten Leiters 8 bzw. die Leiterbereiche 80, 80', 80" erstrecken sich zwischen den betreffenden OLED-Modulen der Spalten *S1, S2* einerseits und dem Trägerelement 6 andererseits bis zur ersten Seite.

In dem in Fig. 2 gezeigten Beispiel ist aufgrund dieser Anordnung davon auszugehen, dass sich etwaige Unterschiede in den elektrischen Wiederständen der Leiter 8, 10 im Wesentlichen ausgleichen können, so dass jedem der OLED-Module 2, 2', 2" der ersten Spalte *S1* derart gleichviel Strom zugeführt werden kann, dass keine Helligkeitsunterschiede zwischen den Lichtabgaben der einzelnen dieser OLED-Module 2, 2', 2" wahrgenommen werden können.

In dem in Fig. 4 gezeigten Ausführungsbei spiel mag es jedoch dazu kommen, dass sich aufgrund der dargestellten geometrischen Unterschiede die Widerstände pro Länge in dem Arm 102 des zweiten Leiters 10 einerseits und den Leiterbereichen 80, 80', 80" andererseits nicht derart ausgleichen und dass es insoweit möglicherweise zu wahrnehmbaren Unterschieden in den Helligkeiten der drei betreffenden OLED-Module 2, 2', 2" kommen kann. Dies lässt sich vorteilhaft dadurch vermeiden, dass die elektrischen Widerstände zwischen den Leiterbereichen 80, 80', 80" und den entsprechenden Kontaktbereichen 22, 24, 22', 24', 22", 24" gezielt beeinflusst werden. Beispielsweise kann hierzu in einem Bereich 86 zwischen dem Leiterbereich 80 und dem ersten Kontaktbereich 22 ein Einschnitt vorgesehen sein, beispielsweise ein mit einem Laser erzeugter Einschnitt. Auf diese Weise kann der elektrische Widerstand in diesem Bereich gezielt erhöht werden, und zwar in Abhängigkeit von der Länge des Einschnitts. Analoges gilt für die weiteren entsprechenden Bereiche zwischen den Leiterbereichen 80, 80', 80" einerseits und den Kontaktbereichen 22, 24, 22', 24', 22", 24" der OLED-Module 2, 2', 2" der betreffenden Spalte *S1* andererseits. Auf diese Weise lässt sich die Stromzufuhr zu den betroffenen OLED-Modulen 2, 2', 2" derart beeinflussen, dass wiederum eine homogen erscheinende Lichtabgabe aller OLED-Module 2, 2', 2" der betreffenden ersten Spalte *S1* erzielt werden kann.

Natürlich ist eine entsprechende Modifizierung der Widerstände auch in den anderen Ausführungsbeispielen möglich.

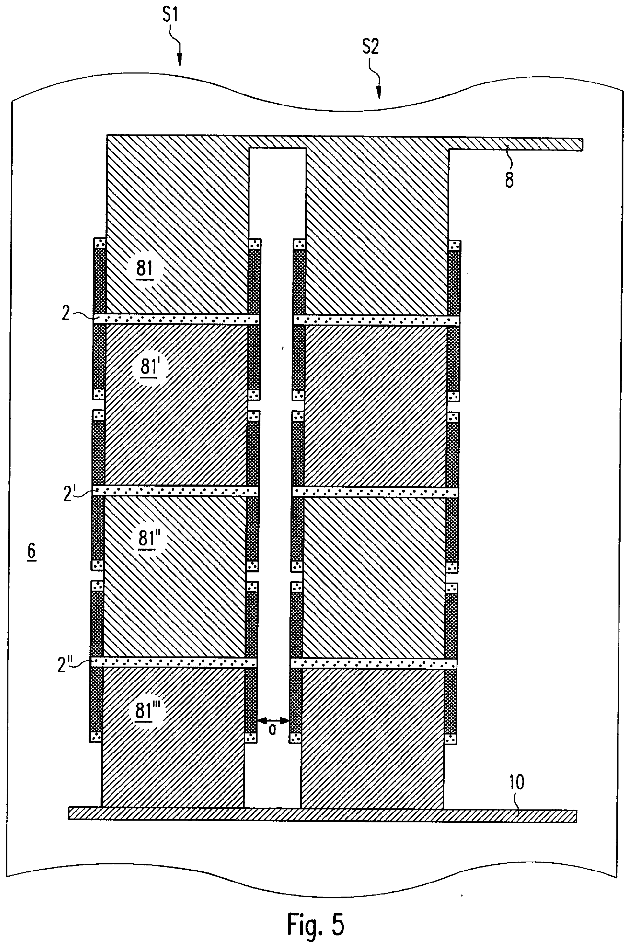

In Fig. 5 ist ein Beispiel (es handelt sich dabei nicht um einen Teil der Erfindung) skizziert. Im Folgenden wird lediglich auf die Unterscheide zu den bisher dargestellten Ausführungsbeispielen eingegangen. Soweit nicht anders angegeben, gelten die obigen Ausführungen auch sinngemäß für dieses Ausführungsbeispiel. Die Bezugszeichen sind analog verwendet.

Im Unterschied zu den bisherigen Ausführungsbeispielen ist hier eine Reihenschaltung der OLED-Module 2, 2', 2" der ersten Spalte *S1* bzw. der zweiten Spalte *S2* bzw. gegebenenfalls weiterer Spalten vorgesehen. Hierdurch ist der Arm 102 des ersten elektrischen Leiters 10 nicht mehr erforderlich und somit lässt sich ein Abstand *a* zwischen der ersten Spalte *S1* und der zweiten Spalte *S2* bzw. allgemeiner zwischen zwei benachbarten Spalten weitergehend verringern. Dies ist vorteilhaft mit Bezug auf eine möglichst homogen erscheinende Abstrahlung des Leuchtelements. Die einzelnen Spalten *S1, S2* können dabei untereinander parallel geschaltet sein.

Zur Realisierung der Reihenschaltung innerhalb der Spalte *S1* können insbesondere mehrere, im gezeigten Beispiel vier Leiterbereiche 81, 81', 81 ", 81"' vorgesehen sein, die jeweils zwischen den OLED-Module 2, 2', 2" der ersten Spalte *S1* einerseits und dem Trägerelement 6 andererseits angeordnet sind. Dabei ist die Anordnung derart, dass in einem mittleren Bereich der ersten Spalte *S1* jeder der Leiterbereiche 81', 81" jeweils überlappend zwischen zwei benachbarten der OLED-Module angeordnet ist und dabei einerseits mit der Anode des einen der beiden OLED-Module elektrisch verbunden ist und andererseits mit der Kathode des anderen der beiden OLED-Module.

Im gezeigten Beispiel ist der Leiterbereich 81' einerseits mit der Anode des OLED-Moduls 2' und andererseits mit der Kathode des ersten OLED-Moduls 2 elektrisch verbunden. Der Leiterbereich 81 " einerseits mit der Anode des OLED-Moduls 2" und andererseits mit der Kathode des OLED-Moduls 2' elektrisch verbunden.

Die beiden randständigen Leiterbereiche 81, 81"' sind jeweils lediglich mit einem OLED-Modul, also mit dem ersten OLED-Modul 2 bzw. dem letzten OLED-Modul 2" der betreffenden Spalte *S1* elektrisch verbunden. Im gezeigten Beispiel ist der Leiterbereich 81 mit der Anode des ersten OLED-Moduls 2 elektrisch verbunden und der Leiterbereich 81"' mit der Kathode des OLED-Moduls 2".

Entsprechendes gilt natürlich wiederum für die zweite Spalte *S2* bzw. gegebenenfalls jeweils für weitere Spalten.

Da OLED-Module grundsätzlich flächige Leuchtkörper darstellen, die eine - im Vergleich zu konventionellen LEDs (LED: lichtemittierende Diode) - moderate Leuchtdichte aufweisen, eignen sie sich zur Herstellung flächiger diffuser Lichtquellen. Insbesondere im professionellen Beleuchtungsbereich ist eine diffuse Beleuchtung eine neue Möglichkeit der Realisierung von großflächigen, hochqualitativen Leuchten. Dabei kann in weiterer Zukunft die OLED durch ihre Dünnschichttechnologie auch die Realisierung von flexiblen bzw. biegbaren Leuchtkörpern ermöglicht werden, die ganz neue Anwendungen in der Beleuchtung von Räumen gestatten. Die vorliegende Erfindung zeigt eine effiziente und dabei vergleichsweise einfach herzustellende Gestaltung eines entsprechenden Leuchtelements.

Beispielsweise kann das hier beschriebene Leuchtelement unmittelbar als Leuchte verwendet werden. In diesem Fall stellt das Leuchtelement die einzige Lichtquelle der Leuchte dar. Es können aber auch mehrere Leuchtelemente als eine Leuchte verwendet werden. Es ist auch möglich, eine Leuchte vorzusehen, die ein Leuchtengehäuse mit einer Lichtaustrittsöffnung aufweist, wobei ein erfindungsgemäßes Leuchtelement als Lichtquelle innerhalb des Leuchtengehäuses angeordnet ist, und zwar derart, dass ein von dem Leuchtelement abgegebenes Licht durch den Lichtaustrittsbereich hindurch die Leuchte verlassen kann. Natürlich können auch mehrere Leuchtelemente als entsprechende Lichtquelle vorgesehen sein.

## Patentansprüche

1. Leuchtelement, aufweisend
- ein erstes OLED-Modul (2),
- ein zweites OLED-Modul (4),
- ein Trägerelement (6), auf dem das erste OLED-Modul (2) und das zweite OLED-Modul (4) angeordnet sind und
- elektrische Leiter (8, 10) zur elektrischen Stromversorgung des ersten OLED-Moduls (2) und des zweiten OLED-Moduls (4),
wobei das erste OLED-Modul (2) wenigstens drei elektrische Kontaktbereiche (22, 24, 26) zur Versorgung mit elektrischem Strom aufweist,
das zweite OLED-Modul (4) wenigstens drei weitere elektrische Kontaktbereiche (42, 44, 46) zur Versorgung mit elektrischem Strom aufweist,
wobei jeder der Kontaktbereiche (22, 24, 26, 42, 44, 46) jeweils mit einem der Leiter (8, 10) elektrisch leitend verbunden ist,
wobei die elektrischen Leiter (8, 10) zumindest teilweise auf dem Trägerelement (6) angeordnet sind und
wobei die Leiter (8, 10) auf dem Trägerelement (6) derart angeordnet sind, dass sie sich nicht überkreuzen,
weiterhin aufweisend
- mehrere weitere OLED-Module (2', 2", 4', 4"), die ebenfalls auf dem Trägerelement (6) angeordnet sind,
wobei das erste OLED-Modul (2), das zweite OLED-Modul (4) und die weiteren OLED-Module (2', 2", 4', 4") derart auf dem Trägerelement (6) angeordnet sind, dass sie Reihen (*R1, R2, R3*) und Spalten (*S1, S2*) bilden,
**dadurch gekennzeichnet,**
**dass** auf dem Trägerelement (6) in einem Grenzbereich zwischen zwei der Spalten (*S1, S2*) ein Arm (102) eines ersten elektrischen Leiters (10) der elektrischen Leiter (8, 10) angeordnet ist, wobei diejenigen der OLED-Module (2, 2', 2", 4, 4', 4"), die eine der zwei Spalten (*S1, S2*) bilden, elektrisch parallel geschaltet sind und mit dem Arm (102) des ersten elektrischen Leiters (10) elektrisch verbunden sind.

2. Leuchtelement nach Anspruch 1,
bei dem das erste OLED-Modul (2) derart geformt ist, dass es einen ersten Randbereich (50) aufweist und einen zweiten Randbereich (52), der dem ersten Randbereich (50) gegenüberliegt,
wobei ein erster Kontaktbereich (22) der drei Kontaktbereiche (22, 24, 26) mit einer ersten Elektrode des ersten OLED-Moduls (2) elektrisch verbunden ist, ein zweiter Kontaktbereich (24) der drei Kontaktbereiche (22, 24, 26) ebenfalls mit der ersten Elektrode des ersten OLED-Moduls (2) elektrisch verbunden ist und
wobei der erste Kontaktbereich (22) an dem ersten Randbereich (50) angeordnet ist und der zweite Kontaktbereich (24) an dem zweiten Randbereich (52).

3. Leuchtelement nach Anspruch 2,
bei dem das erste OLED-Modul (2) eine rechteckige Form, insbesondere eine quadratische Form aufweist,
wobei der erste Randbereich (50) durch einen ersten Seitenbereich der vier, durch die Form festgelegten Seitenbereiche gegeben ist und der zweite Randbereich (52) durch denjenigen weiteren Seitenbereich, der dem ersten Seitenbereich gegenüberliegt oder
der erste Randbereich (50) durch einen, durch die Form festgelegten, ersten Eckenbereich gegeben ist und der zweite Randbereich (52) durch einen weiteren Eckenbereich, der dem ersten Eckenbereich gegenüberliegt.

4. Leuchtelement nach einem der vorhergehenden Ansprüche,
wobei außerdem ein Arm (82) eines zweiten elektrischen Leiters (8) der elektrischen Leiter (8, 10) derart auf dem Trägerelement (6) angeordnet ist, dass er sich zwischen denjenigen OLED-Modulen (2, 2', 2"), die die eine der zwei Spalten (*S1*) bilden, einerseits und dem Trägerelement (6) andererseits erstreckt.

5. Leuchtelement nach einem der vorhergehenden Ansprüche,
bei dem das erste OLED-Modul (2), das zweite OLED-Modul (4) und die weiteren OLED-Module (2', 2", 4', 4") jeweils eine Lichtabgabefläche aufweisen, die größer ist als 1 cm², vorzugsweise größer als 4 cm², besonders bevorzugt größer als 20 cm².

6. Leuchtelement nach einem der vorhergehenden Ansprüche,
bei dem ein elektrischer Leiter (8) der elektrischen Leiter (8, 10) einen zumindest teilweise lichtdurchlässigen Leiterbereich (80, 81) aufweist, der zwischen dem ersten OLED-Modul (2) und dem Trägerelement (6) angeordnet ist.

7. Leuchtelement mit den in den Ansprüchen 2 und 6 genannten Merkmalen, das derart gestaltet ist, dass, in einem Querschnitt durch den ersten Kontaktbereich (22) und den zweiten Kontaktbereich (24) und das Trägerelement (6) betrachtet, zwischen dem ersten OLED-Modul (2) und dem Trägerelement (6) ein länglicher Zwischenraum (90) gebildet ist und der Leiterbereich (80, 81) mehr als die Hälfte, vorzugsweise mehr als 80%, besonders bevorzugt 100% der Längserstreckung des Zwischenraums (90) einnimmt.

8. Leuchtelement nach einem der vorhergehenden Ansprüche,
bei dem das Trägerelement (6) zumindest teilweise lichtdurchlässig ist und beispielsweise aus Glas, PMMA oder aus einer Folie, beispielsweise aus PET besteht oder nicht lichtdurchlässig ist und beispielsweise aus Metall oder Kunststoff besteht.

9. Leuchtelement nach einem der vorhergehenden Ansprüche,
bei dem die drei elektrischen Kontaktbereiche (22, 24, 26) jeweils mit einem der Leiter (8, 10) über einen Leitkleber, eine Weichlötung, ein Flexkabel, einen Klemmkontakt oder einen mechanischen Federkontakt elektrisch leitend verbunden sind.

10. Leuchtelement nach einem der vorhergehenden Ansprüche,
bei dem die elektrischen Leiter (8, 10) aus einem Metall, wie beispielsweise Aluminium, Silber, Chrom oder Kupfer oder aus einer Metalllegierung gebildet sind, das bzw. die auf dem Trägerelement (6) aufgebracht ist oder aus einem transparenten Material gebildet sind, beispielsweise aus ITO, FTO, ZnO oder PEDOT, das auf dem Trägerelement (6) aufgebracht ist.

11. Leuchte, insbesondere zur Raumbeleuchtung,
aufweisend ein Leuchtelement nach einem der vorhergehenden Ansprüche.

12. Leuchte nach Anspruch 11,
bei dem das Leuchtelement die einzige Lichtquelle der Leuchte darstellt.

## Claims

1. A lighting element, having
- a first OLED module (2),
- a second OLED module (4),
- a carrier element (6) on which the first OLED module (2) and the second OLED module (4) are arranged, and
- electrical conductors (8, 10) for supplying electric current to the first OLED module (2) and the second OLED module (4),
wherein the first OLED module (2) has at least three electrical contact regions (22, 24, 26) for the supply of electric current,
the second OLED module (4) has at least three further electrical contact regions (42, 44, 46) for the supply of electric current,
wherein each of the contact regions (22, 24, 26, 42, 44, 46) is connected in an electrically conductive manner to, in each case, one of the conductors (8, 10),
wherein the electrical conductors (8, 10) are arranged at least in part on the carrier element (6), and
wherein the conductors (8, 10) are arranged on the carrier element (6) in such a way that they do not intersect,
having, furthermore,
- a plurality of further OLED modules (2', 2", 4', 4") which are likewise arranged on the carrier element (6),
wherein the first OLED module (2), the second OLED module (4) and the further OLED modules (2', 2", 4', 4") are arranged on the carrier element (6) in such a way that they form rows (*R1, R2, R3*) and columns (*S1*, *S2*),
**characterised in that** arranged on the carrier element (6) in a boundary region between two of the columns (*S1*, *S2*) there is an arm (102) of a first electrical conductor (10) of the electrical conductors (8, 10), wherein those modules of the OLED modules (2, 2', 2", 4, 4', 4") forming one of the two columns (*S1*, *S2*) are connected electrically in parallel and are connected electrically to the arm (102) of the first electrical conductor (10).

2. A lighting element according to claim 1,
in which the first OLED module (2) is shaped in such a way that it has a first edge region (50) and a second edge region (52) lying opposite the first edge region (50),
wherein a first contact region (22) of the three contact regions (22, 24, 26) is electrically connected to a first electrode of the first OLED module (2),
a second contact region (24) of the three contact regions (22, 24, 26) is likewise electrically connected to the first electrode of the first OLED module (2), and
wherein the first contact region (22) is arranged at the first edge region (50), and the second contact region (24) at the second edge region (52).

3. A lighting element according to claim 2,
in which the first OLED module (2) has a rectangular shape, in particular a square shape,
wherein the first edge region (50) is given by a first side region of the four side regions defined by the shape, and the second edge region (52) is given by that further side region lying opposite the first side region, or
the first edge region (50) is given by a first corner region defined by the shape, and the second edge region (52) is given by a further corner region lying opposite the first corner region.

4. A lighting element according to one of the preceding claims,
wherein, moreover, an arm (82) of a second electrical conductor (8) of the electrical conductors (8, 10) is arranged on the carrier element (6) in such a way that it extends between those OLED modules (2, 2', 2") that form the one column of the two columns (*S1*), on the one hand, and the carrier element (6), on the other hand.

5. A lighting element according to one of the preceding claims,
in which the first OLED module (2), the second OLED module (4) and the further OLED modules (2', 2", 4', 4") each have a light-emitting face that is larger than 1 cm², preferably larger than 4 cm², particularly preferably larger than 20 cm².

6. A lighting element according to one of the preceding claims,
in which one electrical conductor (8) of the electrical conductors (8, 10) has a conductor region (80, 81) that is permeable to light at least in part and is arranged between the first OLED module (2) and the carrier element (6).

7. A lighting element having the features mentioned in claims 2 and 6 that is configured in such a way that, viewed in a cross section through the first contact region (22) and the second contact region (24) and the carrier element (6), an elongate interspace (90) is formed between the first OLED module (2) and the carrier element (6), and the conductor region (80, 81) occupies more than half, preferably more than 80%, particularly preferably 100%, of the longitudinal extent of the interspace (90).

8. A lighting element according to one of the preceding claims,
in which the carrier element (6) is permeable to light at least in part, and consists, for example, of glass, PMMA or of a film, for example of PET, or is not permeable to light and consists, for example, of metal or plastics.

9. A lighting element according to one of the preceding claims,
in which the three electrical contact regions (22, 24, 26) are connected in an electrically conductive manner to, in each case, one of the conductors (8, 10) by way of a conductive adhesive, soft-soldering, a flexible cable, a clamping contact or a mechanical spring contact.

10. A lighting element according to one of the preceding claims,
in which the electrical conductors (8, 10) are formed from a metal, such as, for example, aluminium, silver, chromium or copper, or a metal alloy applied to the carrier element (6), or are formed from a transparent material, for example from ITO, FTO, ZnO or PEDOT, applied to the carrier element (6).

11. A luminaire, in particular for illuminating a room, having a lighting element according to one of the preceding claims.

12. A luminaire according to claim 11,
in which the lighting element represents the sole light source of the luminaire.

## Revendications

1. Elément d'éclairage, présentant
- un premier module à OLED (2),
- un deuxième module à OLED (4),
- un élément de support (6), sur lequel sont disposés le premier module à OLED (2) et le deuxième module à OLED (4), et
- des conducteurs (8, 10) électriques servant à alimenter en courant électrique le premier module à OLED (2) et le deuxième module à OLED (4),
sachant que le premier module à OLED (2) présente au moins trois zones électriques de contact (22, 24, 26) servant à l'alimentation en courant électrique,
le deuxième module à OLED (4) présentant au moins trois autres zones de contact (42, 44, 46) électriques servant à l'alimentation en courant électrique,
sachant que chaque zone de contact (22, 24, 26, 42, 44, 46) est reliée de manière électroconductrice respectivement à l'un des conducteurs (8, 10),
sachant que les conducteurs (8, 10) électriques sont disposés au moins en partie sur l'élément de support (6), et
sachant que les conducteurs (8, 10) sont disposés sur l'élément de support (6) de telle manière qu'ils ne se croisent pas,
l'élément d'éclairage présentant en outre,
- plusieurs autres modules à OLED (2', 2", 4', 4"), qui sont disposés de la même manière sur l'élément de support (6),
sachant que le premier module à OLED (2), le deuxième module à OLED (4) et les autres modules à OLED (2', 2", 4', 4") sont disposés sur l'élément de support (6) de telle manière qu'ils forment des rangées (R1, R2, R3) et des colonnes (S1, S2),
**caractérisé en ce**
**qu'**un bras (102) d'un premier conducteur (10) électrique des conducteurs électriques (8, 10) est disposé sur l'élément de support (6) dans une zone limite entre deux des colonnes (S1, S2), sachant que précisément les modules à OLED (2, 2', 2", 4, 4', 4") formant une des deux colonnes (S1, S2) sont branchés d'un point de vue électrique en parallèle et sont reliés électriquement au bras (102) du premier conducteur (10) électrique.

2. Elément d'éclairage selon la revendication 1,
dans le cadre duquel le premier module à OLED (2) est formé de telle manière qu'il présente une première zone de bord (50) et une deuxième zone de bord (52) en regard de la première zone de bord (50),
sachant qu'une première zone de contact (22) des trois zones de contact (22, 24, 26) est reliée électriquement à une première électrode du premier module à OLED (2),
sachant qu'une deuxième zone de contact (24) des trois zones de contact (22, 24, 26) est reliée électriquement de la même manière à la première électrode du premier module à OLED (2), et
sachant que la première zone de contact (22) est disposée au niveau de la première zone de bord (50) et que la deuxième zone de contact (24) est disposée au niveau de la deuxième zone de bord (52).

3. Elément d'éclairage selon la revendication 2,
dans le cadre duquel le premier module à OLED (2) présente une forme rectangulaire, en particulier une forme carrée,
sachant que la première zone de bord (50) est donnée par une première zone latérale des quatre zones latérales fixées par la forme et que la deuxième zone de bord (52) est donnée par l'autre zone latérale en regard de la première zone latérale, ou
sachant que la première zone de bord (50) est donnée par une première zone d'angle fixée par la forme et que la deuxième zone de bord (52) est donnée par une autre zone d'angle en regard de la première zone d'angle.

4. Elément d'éclairage selon l'une quelconque des revendications précédentes,
sachant qu'en outre un bras (82) d'un deuxième conducteur (8) électrique des conducteurs (8, 10) électriques est disposé sur l'élément de support (6) de telle manière qu'il s'étend entre d'une part précisément les modules à OLED (2, 2', 2") formant l'une des deux colonnes (S1) et d'autre part l'élément de support (6).

5. Elément d'éclairage selon l'une quelconque des revendications prédédentes,
dans le cadre duquel le premier module à OLED (2), le deuxième module à OLED (4) et les autres modules à OLED (2', 2", 4', 4") présentent respectivement une surface d'émission de lumière, qui est supérieure à 1 cm², de préférence supérieur à 4 cm², en particulier de manière préférée supérieure à 20 cm².

6. Elément d'éclairage selon l'une quelconque des revendications précédentes,
dans le cadre duquel un conducteur (8) électrique des conducteurs (8, 10) électriques présente une zone conductrice (80, 81) au moins en partie translucide, laquelle est disposée entre le premier module à OLED (2) et l'élément de support (6).

7. Elément d'éclairage présentant les caractéristiques mentionnées dans les revendications 2 et 6, lequel est configuré de telle manière qu'un espace intermédiaire (90) allongé est formé, dans une section transversale par la première zone de contact (22) et la deuxième zone de contact (24) et l'élément de support (6), entre le premier module à OLED (2) et l'élément de support (6) et la zone conductrice (80, 81) occupe plus de la moitié, de préférence plus de 80 %, en particulier de manière préférée 100 % de l'extension longitudinale de l'espace intermédiaire (90).

8. Elément d'éclairage selon l'une quelconque des revendications précédentes,
dans le cadre duquel l'élément de support (6) est au moins en partie translucide et est constitué par exemple de verre, de PMMA ou d'un film, par exemple en PET ou ledit élément de support n'est pas translucide et est constitué par exemple de métal ou de plastique.

9. Elément d'éclairage selon l'une quelconque des revendications précédentes,
dans le cadre duquel les trois zones de contact (22, 24, 26) électriques sont reliées de manière électroconductrice respectivement à l'un des conducteurs (8, 10) par l'intermédiaire d'une colle conductrice, d'un brasage, d'un câble flexible, d'un contact par serrage ou d'un contact mécanique par ressort.

10. Elément d'éclairage selon l'une quelconque des revendications précédentes,
dans le cadre duquel les conducteurs (8, 10) électriques sont formés à partir d'un métal, tel que par exemple l'aluminium, l'argent, le chrome ou le cuivre, ou à partir d'un alliage de métal, lequel métal ou alliage de métal est appliqué sur l'élément de support (6), ou lesdits conducteurs sont formés à partir d'un matériau transparent, par exemple à partir d'ITO, de FTO, de ZnO ou de PEDOT, qui est appliqué sur l'élément de support (6).

11. Lampe, en particulier servant à l'éclairage de pièce,
présentant un élément d'éclairage selon l'une quelconque des revendications précédentes.

12. Lampe selon la revendication 11,
dans le cadre de laquelle l'élément d'éclairage constitue l'unique source de lumière de la lampe.
